# EUROPEAN PATENT APPLICATION

(11) **EP 2 173 145 A2**
(43) Date of publication of application: **07.04.2010**
(21) Application number: 09158889.7
(22) Date of filing: 28.04.2009
(51) Int. Cl.: H05K 1/02, H05K 3/46, H05K 3/24

(54) **Manufacturing method of a flexible printed circuit board and a structure thereof**

(30) Priority: 03.10.2008 TW 97138198
(71) Applicant: Chou, Po-Ju, Zhonghe City Taipei County 235 (TW)
(72) Inventor: Chou, Po-Ju, Zhonghe City Taipei County 235 (TW)
(74) Representative: Harrison, Robert John

(57) **Abstract**

In a manufacturing method of a flexible printed circuit board (100) and its structure, the manufacturing method includes the steps of: providing a substrate (110); performs a preheating and drying process to the substrate; forming a circuit pattern including a ground circuit, a X-axis circuit, a Y-axis circuit and an external circuit on a surface of the substrate by a screen printing method, forming a ground circuit layer (120) on the substrate and corresponding to the ground circuit, forming on a Y-axis circuit layer (130) on a surface of the substrate and corresponding to the Y-axis circuit, forming a X-axis circuit layer (140) on a surface of the substrate and corresponding to the X-axis circuit, and forming a carbon paste enhancement layer (150) according to the external circuit.

## Description

### Field of the Invention

The present invention generally relates to a manufacturing method of a flexible printed circuit board and its structure, and more particularly to a method of using polyethylene terephthalate (PET) or other materials for a substrate to manufacture a large-size flexible printed circuit board by a screen printing method.

### Description of the Related Art

At present, thin display devices are used extensively, such as large screens for outdoor television walls, LCD televisions, plasma televisions and computer displays, or small screens for mobile phone screens, PDA display devices, stock machines and display screens of MP3 and MP4 electronic devices, and the thin display devices are commonly used in our daily life.

As consumers have further requirements on display devices with a larger screen, a higher resolution, a thinner and design, finished goods of the thin display devices become more popular, diversified and refined, and thus multifunctional display devices are introduced to the market and manufacturers continue developing and improving the manufacturing process or the material of the display devices.

In addition, some flexible display devices such as flexible keyboards and electronic books having a thin and light design are used in our daily life.

Most printed circuit boards for the thin flexible display devices are flexible printed circuit boards, and the size of the flexible printed circuit boards becomes increasingly larger and thinner in accordance with the consumer's requirement for the large and thin design.

At present, the materials and manufacturing process of traditional flexible printed circuit boards are systemized, and the aforementioned problems cannot be solved easily, and thus it is necessary to provide new material and manufacturing process for the manufacture of flexible printed circuit boards in order to meet the requirement of the thin and large design.

### Summary of the Invention

Therefore, it is a primary objective of the present invention to provide a manufacturing method of a flexible printed circuit board and its structure, wherein polyethylene terephthalate (PET) or other materials are used for making a substrate, and the flexible printed circuit board is manufactured according to a circuit pattern which is formed by a screen printing method, so as to achieve the purpose of manufacturing a large and thin flexible printed circuit board.

A manufacturing method of a flexible printed circuit board in accordance with the present invention comprises the steps of: (1) providing a substrate; (2) performing a preheating and drying process for the substrate; (3) forming a circuit pattern including at least one ground circuit, at least one X-axis circuit, at least one Y-axis circuit and at least one external circuit on a surface of the substrate; (4) forming at least one ground circuit layer on a surface of the substrate according to the ground circuit; (5) forming at least one Y-axis circuit layer on a surface of the substrate according to the Y-axis circuit; (6) forming at least one X-axis circuit layer on a surface of the substrate according to the X-axis circuit; and (7) forming a carbon paste enhancement layer at the position of the external circuit.

The structure of a flexible printed circuit board in accordance with the present invention comprises a substrate, a circuit pattern, at least one ground circuit layer, at least one Y-axis circuit layer, at least one X-axis circuit layer and at least one carbon paste enhancement layer.

The substrate is made of PET and has a thickness between 100µm and 175µm. The circuit pattern is formed on a surface of the substrate by a screen printing method and includes a ground circuit, a X-axis circuit, a Y-axis circuit and an external circuit, wherein the external circuit is extended from the X-axis circuit, the Y-axis circuit or a combination of the X-axis and Y-axis circuits.

The ground circuit layer further includes at least one ground circuit conductor layer, at least one ground circuit insulating layer formed on the conductor layer, and a plurality of ground circuit conducting holes formed at predetermined positions of the insulating layer.

The Y-axis circuit layer further includes at least one Y-axis circuit conductor layer, at least one Y-axis circuit insulating layer formed on the conductor layer, and a plurality of Y-axis circuit conducting holes formed at predetermined positions of the insulating layer.

The X-axis circuit layer further includes at least one X-axis circuit conductor layer, at least one X-axis circuit insulating layer formed on the conductor layer and a plurality of X-axis circuit conducting holes formed at predetermined positions of the insulating layer.

The ground circuit conductor layer, the Y-axis circuit conductor layer and the X-axis circuit conductor layer are made of silver, copper or another conducting metal.

To make it easier for our examiner to understand the technical characteristics and effects of the present invention, we use preferred embodiments with accompanying drawings for the detailed description of the invention. However, the embodiments and drawings are provided for illustrating the invention, but not intended for limiting the scope of the invention.

### BRIEF DESCRIPTION OF THE DRAWINGS

FIG. 1 is a cross-sectional view of a structure in accordance with a first preferred embodiment of the present invention;
FIG. 2 is a flow chart of a manufacturing method in accordance with a first preferred embodiment of the present invention;
FIG. 3 is a cross-sectional view of a structure in accordance with a second preferred embodiment of the present invention;
FIG. 4 is a cross-sectional view of a structure in accordance with a third preferred embodiment of the present invention; and
FIG. 5 is a flow chart of a manufacturing method in accordance with a second preferred embodiment of the present invention.

### DETAILED DESCRIPTION OF THE PREFERRED EMBODIMENTS

The invention relates to a manufacturing method of a flexible printed circuit board and its structure, wherein polyethylene terephthalate (PET) or other materials are used for making a substrate, and the flexible printed circuit board is manufactured according to a circuit pattern formed by a screen printing method, so as to achieve the purpose of manufacturing a large and thin flexible printed circuit board. The invention is illustrated by preferred embodiments together with related drawings as follows.

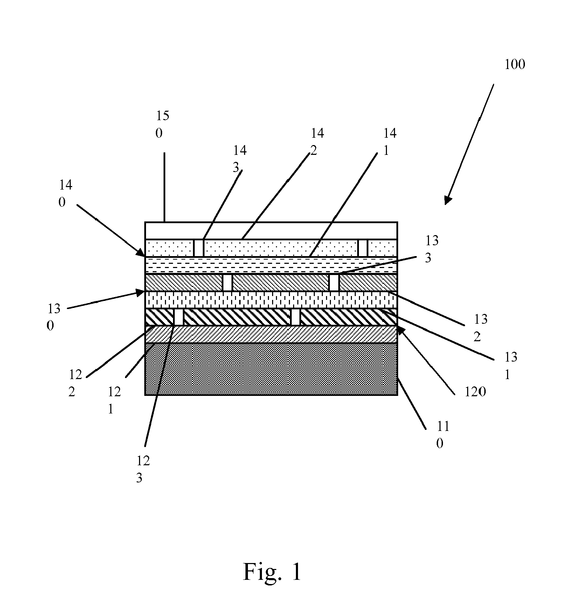

With reference to FIG. 1 for a cross-sectional view of a structure in accordance with a first preferred embodiment of the present invention, the flexible printed circuit board 100 comprises a substrate 110, a circuit pattern (not shown in the figure), a ground circuit layer 120, a Y-axis circuit layer 130, a X-axis circuit layer 140 and a carbon paste enhancement layer 150, wherein the substrate 110 is a transparent film made of polyethylene terephthalate (PET) and has a thickness between 100µm and 175µm.

The circuit pattern is formed on a surface of the substrate 110 by a screen printing method and includes a ground circuit, a Y-axis circuit, a X-axis circuit and a circuit design of an external circuit formed by extending the X-axis circuit, the Y-axis circuit or a combination of X-axis and Y-axis circuits. The ground circuit layer 120, the Y-axis circuit layer 130, the X-axis circuit layer 140 and the carbon paste enhancement layer 150 are coated layer by layer onto a surface of the substrate 110 according to the circuit design.

The ground circuit layer 120 is formed on a surface of the substrate 110 according to the ground circuit, and further includes a ground circuit conductor layer 121, a ground circuit insulating layer 122 and a plurality of ground circuit conducting holes 123. The conductor layer 121 is formed on a lateral surface of the substrate 110 and the insulating layer 122 is attached onto the conductor layer 121, and the insulating layer 122 includes a plurality of conducting holes 123 disposed thereon and used for an electric connection.

The Y-axis circuit layer 130 is formed on the ground circuit layer 120 according to the Y-axis circuit and further includes a Y-axis circuit conductor layer 131, a Y-axis circuit insulating layer 132 and a plurality of Y-axis circuit conducting holes 133. The conductor layer 131 is formed on the ground circuit insulating layer 122 first and then attached onto the insulating layer 132, and the insulating layer 132 includes a plurality of conducting holes 133 formed at predetermined positions for an electric connection.

The X-axis circuit layer 140 is formed on the Y-axis circuit layer 130 according to the X-axis circuit and further includes a X-axis circuit conductor layer 141, a X-axis circuit insulating layer 142 and a plurality of X-axis circuit conducting holes 143. The conductor layer 141 is formed on the Y-axis circuit insulating layer 132 first and then attached onto the insulating layer 142. The insulating layer 142 includes a plurality of conducting holes 143 formed at predetermined positions for an electric connection.

The carbon paste enhancement layer 150 is formed on the external circuit for protecting the flexible printed circuit board 100 externally connected to an external circuit from being worn out, damaged or having a poor contact caused by frequent plugging and unplugging, and such worn-out, damage, or poor contact will affect the electric connection function.

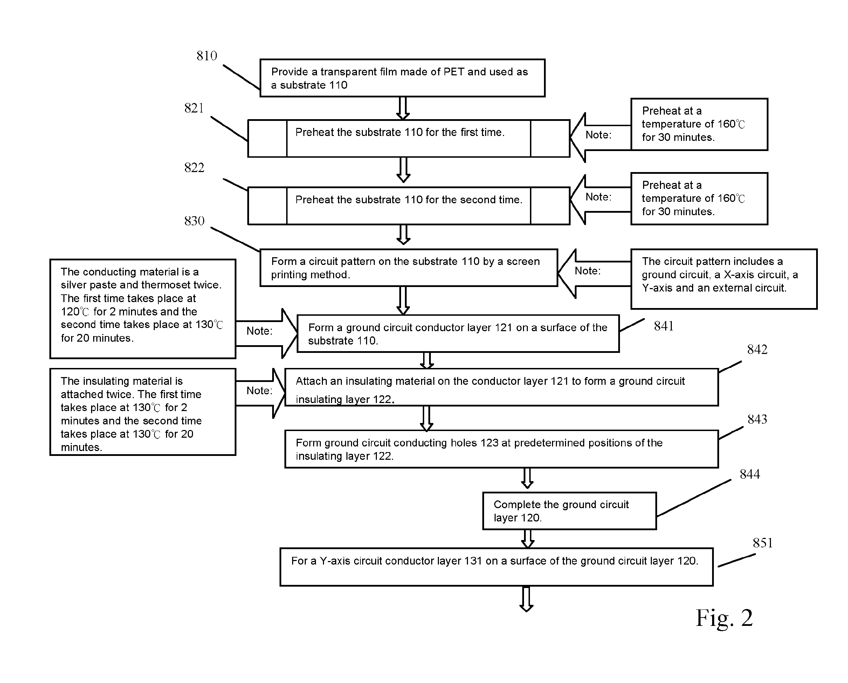

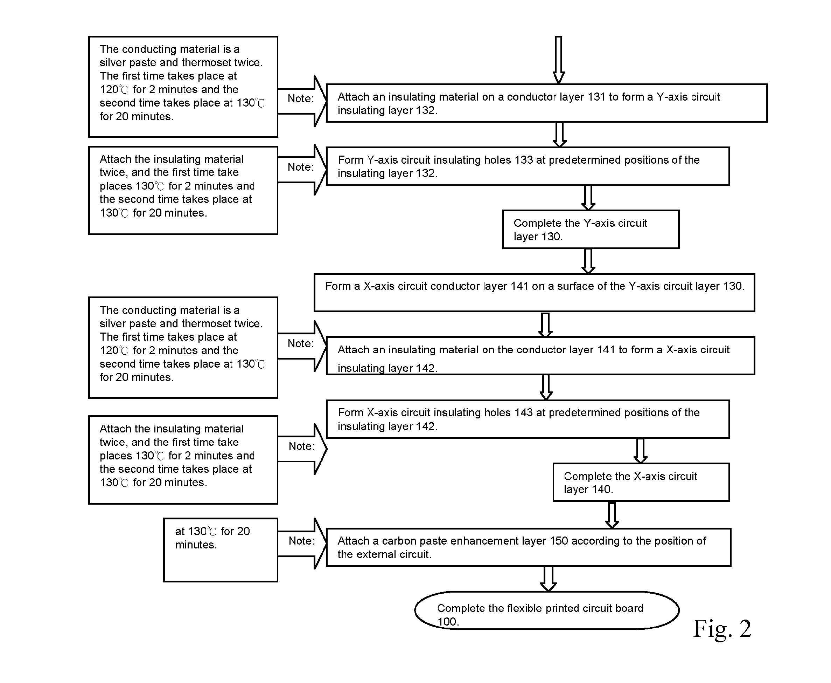

With reference to FIG. 2 for a flow chart of a manufacturing method in accordance with a first preferred embodiment of the present invention, the method comprises the steps of: providing a transparent film made of PET (Step 810) and used as a substrate 110 of the flexible printed circuit board; preheating and drying the substrate 110 twice (Steps 821 and 822), wherein the first-time preheating and drying process preferably takes place at a temperature of 160°C for a preheat time of 30 minutes, and the second-time preheating and drying process also preferably takes place at a temperature of 160°C for a preheat time of 30 minutes.

In Step 830, a circuit pattern is formed on a surface of the substrate 110 by a screen printing method and includes a ground circuit, a X-axis circuit, a Y-axis circuit and a circuit design of an external circuit formed by extending the X-axis circuit, the Y-axis circuit or a combination of X-axis and Y-axis circuits.

In Steps 841 to 844, silver, copper or another conducting metal is thermoset on a surface of the substrate 110 according to the position of the ground circuit to form a ground circuit conductor layer 121, and then an insulating material is attached to form a ground circuit insulating layer 122, and a plurality of ground circuit conducting holes 123 are formed at predetermined positions of the insulating layer 122 to complete the formation of the ground circuit layer 120. In the thermosetting process of forming the ground circuit conductor layer 121, a baking and thermosetting process of the silver paste is performed twice, wherein the first-time process preferably takes place at 120°C for 2 minutes and the second-time process preferably takes place at 130°C for 20 minutes. The insulating material of the insulating layer 122 is preferably attached twice, wherein the first-time attachment preferably takes place at 130°C for 2 minutes, and the second-time attachment preferably takes place at 130°C for 20 minutes.

In Steps 851 to 854, silver, copper or another conducting metal is thermoset on a surface of the ground circuit layer 120 according to the predetermined position of the Y-axis circuit to form a Y-axis circuit conductor layer 131. An insulating material is attached to form a Y-axis circuit insulating layer 132, and then a plurality of Y-axis circuit conducting holes 133 are formed at predetermined positions of the insulating layer 132 to complete the formation of the Y-axis circuit layer 130. In the thermosetting process of forming the Y-axis circuit conductor layer 131, a baking and thermosetting process of silver paste is performed twice, wherein the first-time process preferably takes place at 120°C for 2 minutes and the second-time process preferably takes place at 130°C for 20 minutes. The insulating material of the insulating layer 132 is preferably attached twice, wherein the first-time attachment preferably takes place at 130°C for 2 minutes, and the second-time attachment preferably takes place at 130°C for 20 minutes.

In Steps 861 to 864, silver, copper or another conducting metal is thermoset on a surface of the Y-axis circuit layer 130 according to a predetermined position of the X-axis circuit to form a X-axis circuit conductor layer 141, and then an insulating material is attached to form an X-axis circuit insulating layer 142, and a plurality of X-axis circuit conducting holes 143 are formed at predetermined positions of the insulating layer 142 to complete the formation of the X-axis circuit layer 140.

In the thermosetting process of forming the Y-axis circuit conductor layer 141, a baking and thermosetting process of silver paste is performed twice, wherein the first-time process preferably takes place at 120°C for 2 minutes and the second-time process preferably takes place at 130°C for 20 minutes. The insulating material of the insulating layer 142 is preferably attached twice, wherein the first-time attachment preferably takes place at 130°C for 2 minutes, and the second-time attachment preferably takes place at 130°C for 20 minutes.

In Step 871, an external circuit formed by extending the X-axis circuit, the Y-axis circuit or the combination of X-axis and Y-axis circuits according to the predetermined position of the external circuit may be formed at this position to enhance the adhesion of the carbon paste enhancement layer 150, and the process preferably takes place at 130°C for 20 minutes, until the structure of the flexible printed circuit board is produced as shown in Step 880.

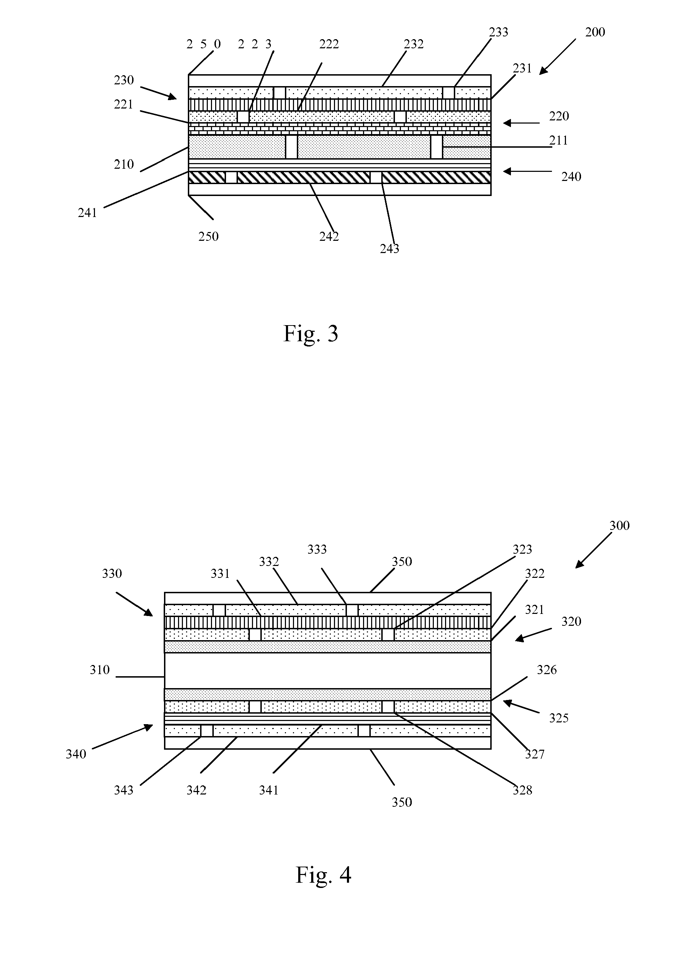

With the foregoing manufacturing method and process, the same substrate and conducting material used for manufacturing the flexible printed circuit board according to requirements of different products, the structure of the flexible printed circuit board may vary. With reference to FIG. 3 for a cross-sectional view of a structure in accordance with a second preferred embodiment of the present invention, the structure of the flexible printed circuit board 200 comprises a substrate 210, a circuit pattern (not shown in the figure), a ground circuit layer 220, a Y-axis circuit layer 230, a X-axis circuit layer 240 and a carbon paste enhancement layer 250. Similarly, the circuit pattern is formed on a surface of the substrate 210 by a screen printing method and includes a ground circuit, a Y-axis circuit, a X-axis circuit and an external circuit formed by the X-axis circuit, the Y-axis circuit or a combination of the X-axis and Y-axis circuits. The substrate 210 is also a transparent film made of PET, but the substrate 210 includes a plurality of conducting holes 211 formed on the surface of the substrate 210 according to the design of the circuit pattern.

The ground circuit layer 220, the Y-axis circuit layer 230, the X-axis circuit layer 240 and the carbon paste enhancement layer 250 are coated on both lateral surfaces of the substrate 210 according to the circuit design, wherein the ground circuit layer 220 is formed on a lateral surface of the substrate 210 according to the ground circuit and includes a ground circuit conductor layer 221 and further forms a ground circuit insulating layer 222 thereon, and a plurality of conducting holes 223 are disposed on the insulating layer 222 and provided for an electric connection.

The Y-axis circuit layer 230 is formed on the ground circuit layer 220 and includes a ground circuit insulating layer 222, and forms a Y-axis circuit conductor layer 231 on a Y-axis circuit insulating layer 232, and a plurality of Y-axis circuit conducting holes 233 are formed on the insulating layer 232.

The X-axis circuit layer 240 is formed on another lateral side of the substrate 210 and includes a X-axis circuit conductor layer 241, a X-axis circuit insulating layer 242 and a plurality of X-axis circuit conducting holes 243. The conductor layer 241 is formed on another lateral surface of the substrate 210 first, and a plurality of conducting holes 211 formed on the substrate 210 are electrically coupled to the ground circuit layer 220, and an insulating layer 242 is attached onto the conductor layer 241, and the insulating layer 242 includes a plurality of conducting holes 243 formed at predetermined positions and provided for an electric connection.

Similarly, the carbon paste enhancement layer 250 is formed onto the external circuit for protecting the flexible printed circuit board 200 and the external circuit externally connected to an external circuit from being worn out, damaged or having a poor contact caused by frequent plugging and unplugging, and such worn-out, damage or poor contact will affect the electric connection function.

With reference to FIG. 4 for a cross-sectional view of a structure in accordance with a third preferred embodiment of the present invention, a structure of the flexible printed circuit board 300 comprises a substrate 310, a circuit pattern, a ground circuit layer 320, a Y-axis circuit layer 330, a X-axis circuit layer 340 and a carbon paste enhancement layer 350. The circuit pattern is also formed on a surface of the substrate 310 by a screen printing method, and similarly includes a ground circuit, a Y-axis circuit, a X-axis circuit and an external circuit formed by extending the X-axis circuit, the Y-axis circuit or a combination of the X-axis and Y-axis circuits, and the substrate 310 is also a transparent film made of PET.

Similarly, the ground circuit layers 320, 325 are coated on both lateral surfaces of the substrate 310 respectively, each including a ground circuit conductor layer 321, 326 disposed separately on both lateral surfaces of the substrate 310, and then the ground circuit insulating layers 322, 327 are formed onto the ground circuit conductor layer 321, 326 and a plurality of conducting holes 323, 328 are formed at predetermined positions of the insulating layers 322, 327 respectively and provided for an electric connection.

The Y-axis circuit layer 330 and the X-axis circuit layer 340 are formed on the ground circuit layers 320, 325 respectively, and the circuits on the conductor layers 331, 341 are attached onto the insulating layers 322, 327, and the ground circuit layer conducting holes 323, 328 are electrically coupled to the ground circuit conductor layers 321, 326. The Y-axis circuit insulating layer 332 and the X-axis circuit insulating layer 342 are also attached onto the conductor layers 331, 341 of the two layers 322, 345, and the Y-axis circuit conducting hole 333 and the X-axis circuit conducting hole 343 are formed on the insulating layers 332, 342, and finally the carbon paste enhancement layer 350 is attached and formed on the external circuit.

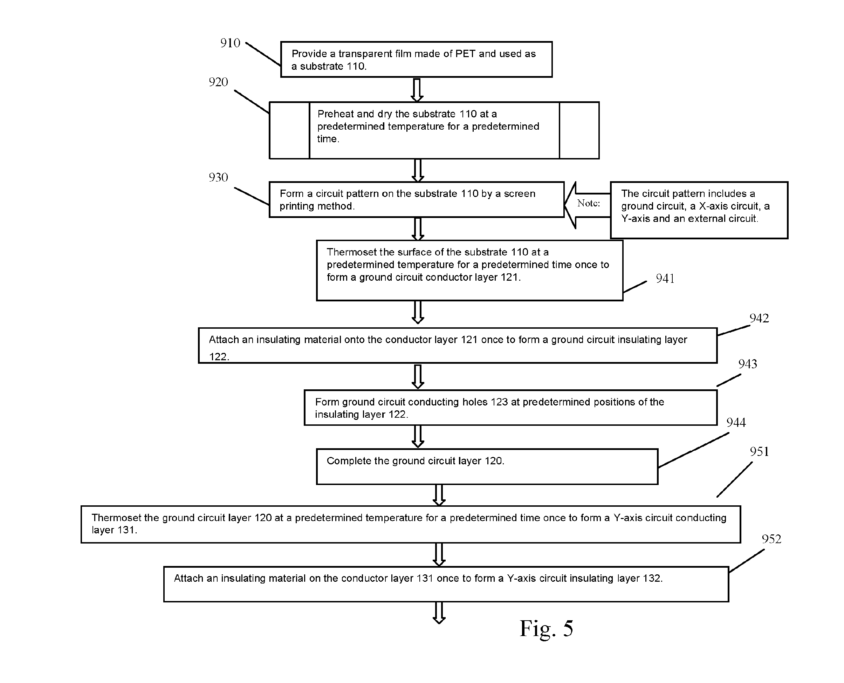

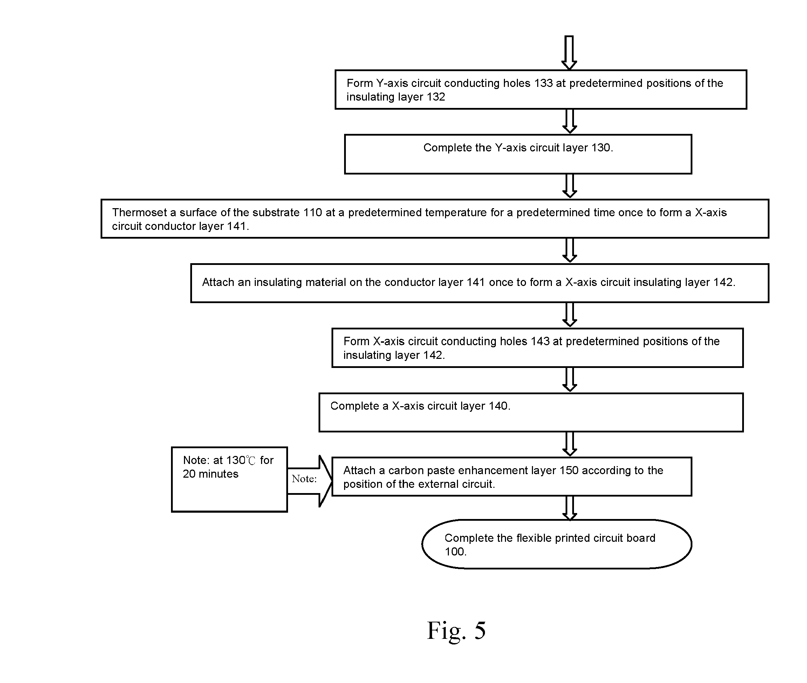

Based on the requirement, quality, efficiency and cost of different products, different manufacturing procedures are used to achieve the structures of the flexible printed circuit boards in accordance with the first, second and third preferred embodiments of the present invention. With reference to FIG. 5 for another manufacturing flow chart of the flexible printed circuit board of the invention, the procedure is substantially the same as the procedure as shown in the first preferred embodiment. For instance, the transparent film as shown in Step 910 is made of PET and used as a substrate 110 of the flexible printed circuit board, and a preheating and drying process is performed to the substrate 110 at a predetermined temperature for a predetermined time once as shown in Step 920, and a ground circuit, a X-axis circuit, a Y-axis circuit and an external circuit formed by extending the X-axis circuit, the Y-axis circuit or a combination of the X-axis and Y-axis circuits are formed on a surface of the substrate 110 as shown in Step 930, and similarly includes a circuit pattern formed by a screen printing method. In Steps 941 to 944, silver, copper or another conducting metal is thermoset on a surface of the substrate 110 according to a predetermined position of the ground circuit, and then a ground circuit conductor layer 121 is performed at a predetermined temperature for a predetermined time, and an insulating material is attached to form a ground circuit insulating layer 122, and then a plurality of ground circuit conducting holesl23 are disposed at predetermined positions of the insulating layer 122 to complete the formation of the ground circuit layer 120.

In Steps 951 to 954, silver, copper or another conducting metal is thermoset on a surface of the ground circuit layer 120 according to a predetermined position of the Y-axis circuit to form a Y-axis circuit conductor layer 131, and then an insulating material is attached once to form a Y-axis circuit insulating layer 132, and a plurality of Y-axis circuit conducting holes 133 are formed at predetermined positions of the insulating layer 132 to complete the formation of the Y-axis circuit layer 130.

In Steps 961 to 964, silver, copper or another conducting metal is thermoset on a surface of substrate 110 once at a predetermined temperature and a predetermined time to form a X-axis circuit conductor layer 141, and then an insulating material is attached once to form a X-axis circuit insulating layer 142, and a plurality of X-axis circuit conducting holes 143 are formed at predetermined positions of the insulating layer 142 to complete the formation of the X-axis circuit layer 140.

In Steps 970 and 980, a carbon paste enhancement layer 150 is thermoset according to a predetermined position of the external circuit, and the external circuit is formed by extending a X-axis circuit, a Y-axis circuit or a combination of the X-axis and Y-axis circuits to complete manufacturing the structure of the flexible printed circuit board.

In summation of the description above, the present invention improves over the prior art and complies with the patent application requirements, and thus is duly filed for patent application. While the invention has been described by means of specific embodiments, numerous modifications and variations could be made by those skilled in the art without departing from the scope and spirit of the invention set forth in the claims.

## Claims

1. A manufacturing method of a flexible printed circuit board, comprising the steps of:
(1) providing a substrate;
(2) performing a reheating and drying process to the substrate;
(3) forming a circuit pattern including at least one ground circuit, at least one X-axis circuit, at least one Y-axis circuit and at least one external circuit on a surface of the substrate;
(4) forming at least one ground circuit layer on a surface of the substrate according to the ground circuit;
(5) forming at least one Y-axis circuit layer on a surface of the substrate according to the Y-axis circuit;
(6) forming at least one X-axis circuit layer on a surface of the substrate according to the X-axis circuit; and
(7) forming a carbon paste enhancement layer at the position of the external circuit.

2. The manufacturing method of a flexible printed circuit board as recited in claim 1, wherein the preheating and drying process of the Step (2) is performed for one or more times at a predetermined temperature for a predetermined time.

3. The manufacturing method of a flexible printed circuit board as recited in claim 1, wherein the circuit pattern of the Step (3) is formed by a screen printing method.

4. The manufacturing method of a flexible printed circuit board as recited in claim 1, wherein the Step (4) further comprises:
(4A) forming at least one ground circuit conductor layer;
(4B) attaching at least one insulating layer onto the ground circuit conductor layer; and
(4C) forming a plurality of ground circuit layer conducting holes at predetermined positions on the insulating layer.

5. The manufacturing method of a flexible printed circuit board as recited in claim 4, wherein the ground circuit conductor layer of the Step (4A) is thermoset for one or more times at a predetermined temperature for a predetermined time.

6. The manufacturing method of a flexible printed circuit board as recited in claim 4, wherein the insulating material of the Step (4B) is attached for one or more times at a predetermined temperature for a predetermined time.

7. The manufacturing method of a flexible printed circuit board as recited in claim 1, wherein the Step (5) further comprises:
(5A) forming at least one Y-axis circuit conductor layer;
(5B) attaching at least one insulating layer onto the Y-axis circuit conductor layer; and
(5C) forming a plurality of Y-axis circuit layer conducting holes at predetermined positions on the insulating layer.

8. The manufacturing method of a flexible printed circuit board as recited in claim 7, wherein the Y-axis circuit conductor layer of the Step (5A) is thermoset for one or more times at a predetermined temperature for a predetermined time.

9. The manufacturing method of a flexible printed circuit board as recited in claim 7, wherein the insulating material of the Step (5B) is attached for one or more times at a predetermined temperature for a predetermined time.

10. The manufacturing method of a flexible printed circuit board as recited in claim 1, wherein the Step (6) further comprises:
(6A) forming at least one X-axis circuit conductor layer;
(6B) attaching at least one insulating layer onto the X-axis circuit conductor layer; and
(6C) forming a plurality of X-axis circuit layer conducting holes at predetermined positions on the insulating layer.

11. The manufacturing method of a flexible printed circuit board as recited in claim 10, wherein the X-axis circuit conductor layer of the Step (6A) is thermoset for one or more times at a predetermined temperature for a predetermined time.

12. The manufacturing method of a flexible printed circuit board as recited in claim 10, wherein the insulating material of the Step (6B) is attached for one or more times at a predetermined temperature for a predetermined time.

13. The manufacturing method of a flexible printed circuit board as recited in claim 1, wherein the Step 7 the carbon paste enhancement layer is thermoset at a predetermined temperature for a predetermined time and covered onto a circuit layer of the external circuit.

14. A structure of a flexible printed circuit board, comprising:
a substrate;
a circuit pattern, formed on a surface of the substrate by a screen printing method, and having at least one ground circuit, at least one X-axis circuit, at least one Y-axis circuit and at least one external circuit;
at least one ground circuit layer, formed on the ground circuit, and disposed on a lateral surface of the substrate;
forming at least one Y-axis circuit layer on the Y-axis circuit disposed on the ground circuit layer;
forming at least one X-axis circuit layer on the X-axis circuit disposed on the Y-axis circuit layer; and
forming at least one carbon paste enhancement layer at the external circuit.

15. The structure of a flexible printed circuit board as recited in claim 14, wherein the substrate is made of polyethylene terephthalate (PET), and has a thickness from 100µm to 175µm.

16. The structure of a flexible printed circuit board as recited in claim 14, wherein the external circuit is extended from the X-axis circuit, the Y-axis circuit or a combination of the X-axis and Y-axis circuits.

17. The structure of a flexible printed circuit board as recited in claim 14, wherein the ground
circuit layer further comprises:
at least one ground circuit conductor layer;
at least one ground circuit insulating layer, formed on the conductor layer; and a plurality of ground circuit conducting holes, disposed at predetermined positions of the insulating layer.

18. The structure of a flexible printed circuit board as recited in claim 17, wherein the ground circuit conductor layer is made of silver, copper or another conducting metal.

19. The structure of a flexible printed circuit board as recited in claim 14, wherein the Y-axis circuit layer further comprises:
at least one Y-axis circuit conductor layer;
at least one Y-axis circuit insulating layer, formed on the conductor layer; and
a plurality of Y-axis circuit conducting holes, disposed at predetermined positions of the insulating layer.

20. The structure of a flexible printed circuit board as recited in claim 19, wherein the Y-axis circuit conductor layer is made of silver, copper or another conducting metal.

21. The structure of a flexible printed circuit board as recited in claim 14, wherein the X-axis circuit layer further comprises:
at least one X-axis circuit conductor layer;
at least one X-axis circuit insulating layer, formed on the conductor layer; and
a plurality of X-axis circuit conducting holes, disposed at predetermined positions of the insulating layer.

22. The structure of a flexible printed circuit board as recited in claim 21, wherein the X-axis circuit conductor layer is made of silver, copper or another conducting metal.

23. A structure of a flexible printed circuit board, comprising:
a substrate;
a circuit pattern, formed on a surface of the substrate by a screen printing method, and having at least one ground circuit, at least one X-axis circuit, at least one Y-axis circuit and at least one external circuit;
at least one ground circuit layer, formed on the ground circuit, and disposed on a first lateral surface of the substrate;
at least one Y-axis circuit layer, formed on the Y-axis circuit disposed on the ground circuit layer;
at least one X-axis circuit layer, formed on the X-axis circuit disposed on a second lateral surface of the substrate corresponding to the first lateral surface; and at least one carbon paste enhancement layer, formed at the external circuit.

24. The structure of a flexible printed circuit board as recited in claim 23, wherein the substrate is made of polyethylene terephthalate (PET), and has a thickness from 100µm to 175µm.

25. The structure of a flexible printed circuit board as recited in claim 23, wherein the substrate includes a plurality of conducting holes for electrically coupling the X-axis circuit layer and the ground circuit layer.

26. The structure of a flexible printed circuit board as recited in claim 23, wherein the external circuit is extended from the X-axis circuit, the Y-axis circuit or a combination of the X-axis and Y-axis circuits.

27. The structure of a flexible printed circuit board as recited in claim 23, wherein the ground circuit layer further comprises:

28. at least one ground circuit conductor layer, made of silver, copper or another conducting metal;
at least one ground circuit insulating layer, formed on the conductor layer; and a plurality of ground circuit conducting holes, formed at predetermined positions of the insulating layer.

29. The structure of a flexible printed circuit board as recited in claim 23, wherein the Y-axis circuit layer further comprises:
at least one Y-axis circuit conductor layer, made of silver, copper or another conducting metal;
at least one Y-axis circuit insulating layer, formed on the conductor layer; and
a plurality of Y-axis circuit conducting holes, formed at predetermined positions of the insulating layer.

30. The structure of a flexible printed circuit board as recited in claim 23, wherein the X-axis circuit layer, further comprises:
at least one X-axis circuit conductor layer, made of silver, copper or another conducting metal;
at least one X-axis circuit insulating layer, formed on the conductor layer; and
a plurality of X-axis circuit conducting holes, formed at predetermined positions of the insulating layer.

31. A structure of a flexible printed circuit board, comprising:
a substrate;
a circuit pattern, formed on a surface of the substrate by a screen printing method, and having at least one ground circuit, at least one X-axis circuit, at least one Y-axis circuit and at least one external circuit;
at least two ground circuit layers, formed on the ground circuit, and disposed on a first lateral surface and a second lateral surface of the substrate respectively;
at least one Y-axis circuit layer, formed on the Y-axis circuit, and disposed on the first lateral surface of the ground circuit layer;
at least one X-axis circuit layer, formed on the X-axis circuit, and disposed on the ground circuit layer of the second lateral surface; and
at least one carbon paste enhancement layer formed at the external circuit.

32. The structure of a flexible printed circuit board as recited in claim 30, wherein the substrate is made of polyethylene terephthalate (PET), and has a thickness from 100µm to 175µm.

33. The structure of a flexible printed circuit board as recited in claim 30, wherein the external circuit is extended from the X-axis circuit, the Y-axis circuit or a combination of the X-axis and Y-axis circuits.

34. The structure of a flexible printed circuit board as recited in claim 30, wherein the ground circuit layer further comprises:
at least one ground circuit conductor layer, made of silver, copper or another conducting metal;
at least one ground circuit insulating layer, formed on the conductor layer; and a plurality of ground circuit conducting holes, formed at predetermined positions of the insulating layer.

35. The structure of a flexible printed circuit board as recited in claim 30, wherein the Y-axis circuit layer further comprises:
at least one Y-axis circuit conductor layer, made of silver, copper or another conducting metal;
at least one Y-axis circuit insulating layer, formed on the conductor layer; and
a plurality of Y-axis circuit conducting holes, formed at predetermined positions of the insulating layer.

36. The structure of a flexible printed circuit board as recited in claim 30, wherein the X-axis circuit layer further comprises:
at least one X-axis circuit conductor layer, made of silver, copper another conducting metal;
at least one X-axis circuit insulating layer, formed on the conductor layer; and
a plurality of X-axis circuit conducting holes, formed at predetermined positions of the insulating layer.
